(19) Europäisches Patentamt
European Patent Office
Office européen des brevets

(11) EP 1 242 997 B1

(12) **EUROPEAN PATENT SPECIFICATION**

(45) Date of publication and mention
of the grant of the patent:
**29.10.2003 Bulletin 2003/44**

(51) Int Cl.[7]: **G11C 13/04**, G03C 1/705,
G11B 7/24, G03H 1/02

(21) Application number: **00985585.9**

(22) Date of filing: **15.12.2000**

(86) International application number:
**PCT/GB00/04833**

(87) International publication number:
**WO 01/045111 (21.06.2001 Gazette 2001/25)**

(54) **PHOTOREFRACTIVE HOLOGRAPHIC RECORDING MEDIA**

PHOTOREFRAKTIVES HOLOGRAPHISCHES AUFZEICHNUNGSMEDIUM

SUPPORT D'ENREGISTREMENT HOLOGRAPHIQUE PHOTOREFRACTIF

(84) Designated Contracting States:
**AT BE CH CY DE DK ES FI FR GB GR IE IT LI LU
MC NL PT SE TR**
Designated Extension States:
**AL LT LV MK RO SI**

(30) Priority: **17.12.1999 GB 9929953**

(43) Date of publication of application:
**25.09.2002 Bulletin 2002/39**

(73) Proprietor: **Polight Technologies Ltd.
Cambridge CB4 0WF (GB)**

(72) Inventors:
• **ELLIOTT, Stephen
Cambridge CB5 8AA (GB)**
• **KRECMER, Pavel
Cambridge CB1 2NU (GB)**

(74) Representative: **Finnie, Peter John
Gill Jennings & Every,
Broadgate House,
7 Eldon Street
London EC2M 7LH (GB)**

(56) References cited:
**US-A- 3 825 317**

• **KARNATOVSKIJ ET AL.: "High-efficiency phase
hologram recording in chalcogenide films at
elevated temperatures" SOVIET JOURNAL OF
QUANTUM ELECTRONICS., vol. 7, no. 5, 1980,
pages 636-638, XP002162550 AMERICAN
INSTITUTE OF PHYSICS. WOODBURY, NY., US**
• **DATABASE WPI Section Ch, Week 198647
Derwent Publications Ltd., London, GB; Class
L03, AN 1986-310836 XP002162434 & SU 1 223
201 A (UNIV NOVOS), 7 April 1986 (1986-04-07)**
• **DATABASE CHEMABS [Online] CHEMICAL
ABSTRACTS SERVICE, COLUMBUS, OHIO, US;
KARNATOVSKII, V. E. ET AL: "Possible
temperature regulation of properties of
holograms in media based on chalcogenide
glass-like semiconductors" retrieved from STN
Database accession no. 87:159988 CA
XP002162433 & KVANTOVAYA ELEKTRON.
(MOSCOW) (1977), 4(6), 1296-300 , 1977,**
• **DATABASE WPI Section Ch, Week 198134
Derwent Publications Ltd., London, GB; Class
G08, AN 1981-61647D XP002162435 & SU 775 761
A (UZHGOROD UNIV), 10 November 1980
(1980-11-10)**

## Description

The present invention relates generally to materials used for forming photorefractive holographic recording media. In particular but not exclusively the invention relates to a group of materials which are usable as nonvolatile rewriteable holographic media.

We now live in an information-driven age, and one of the key limiting bottlenecks concerns the storage and rapid retrieval of the data involved. Permanently recorded CDs consist of a series of pits and grooves etched into the surface, and rewriteable CDs employ surface crystallisation/amorphization of a thin amorphous layer, in which the information is digitally encoded and read optically. Magnetic discs likewise store digital information in the form of differently aligned magnetic domains on the surface of a magnetic medium. The data-storage business is huge : the annual sales revenues of disc drives in 2002 is predicted to be more than 50 billion dollars.

Data storage based on two dimensional (2D) memories, such as optically read/write pits, grooves or magnetic domains are reaching the theoretical limits of the given materials. New techniques are being sought in order to decrease the price per megabyte and increase the data storage capacity and speed of data recording and retrieval of near-future disk drives by several orders of magnitude. The technical solutions to the problem are essentially three-fold. Firstly, decreasing the pit and groove sizes to several nanometres would reach the limit of $10^{10}$-$10^{12}$ bits/mm$^2$. Such a solution is, however, inevitably limited by costly precision mechanics, need for special environment (high-vacuum or pure liquid state) and most importantly, extra long access time to stored data due to the inherent disadvantage of 2D technology - very slow serial reading.

The second technical solution to the increasing demands for data-storage systems is being developed on the basis of three-dimensional optical writing of pits and grooves into a series of multi-layers. Instead of one layer in today's CDs or two layers in today's DVDs, multilayer disks are beings considered using, for example, photorefractive polymers or fluorescent materials. This technical solution to the data-storage problem also has severe disadvantages, such as the limited number of sensitive layers due to overlapping problems (noise due to interference and scattering) and still, most importantly, slow serial data processing.

The third category of technical approach to data-storage systems for future disk drives is in holographic data recording and retrieval. It is thus an aim of the present invention to at least partly mitigate the above mentioned problems.

In this, whole "pages" of information can be stored in a single hologram stored in a medium, and many holograms can be simultaneously stored in a 3D region. The theoretical limit for data storage using this method is approximately $10^{10}$bits/mm$^3$ (compared with say N X 4 X $10^6$ bits/mm$^2$ for an N-layer CD), thus offering the prospect of data-storage systems being able to store terabytes of information, orders of magnitude greater than is possible using current technologies. Of equal (or greater) importance is that retrieval rates for stored data are also correspondingly much greater (of order Gbit/sec) because whole holograms (pages) are read at once rather than the information being read bit-by-bit.

It is generally accepted that a suitable recording has not been commercially available. Virtually any photo-sensitive material can be used for holographic recording; however, long-time data storage, sensitivity, cost, speed of recording, developing of the holograms are only some of the issues which limit the available materials to a few which are potentially useful in the field of holographic data storage. Typical materials extensively used in, for example, art holography, such as silver-halide materials, dichromated gelatin, bacteriorhodospin etc. are generally unsuitable for data storage as they typically require wet processing and are irreversible. Thus, there are, in principal, two major groups of materials being extensively studied at present.

The first of these, ion-doped ferroelectric oxides, such as lithium niobate, have served for laboratory use for many years. Holograms recorded in these materials consist of bulk space-charge patterns. Disadvantages include: costliness, poor sensitivity (need for very high light power densities) and the danger of noise due to damage inflicted during read-out. Also to reach the theoretical limits of the material, the need for wavelength and/or angle multiplexing methods in precisely aligned crystals requires very costly apparatus etc.

The second of these, polymer recording, is promising and is gaining increased popularity due to the simple method of preparation and relatively low cost. Several physical principles are utilized in polymer recording. Materials for such an application need to be either dependent on a refractive-index change resulting from polymerization in illuminated areas (essentially an irreversible process, a write-only-once type of memory with significant distortions of the holograms due to polymer shrinkage during polymerization) or a patterning of photoliberal trapped charge by interfering laser beams which leads to space-charge field formation and thus a refractive-index modulation; these are photorefractive polymers (reversible, however with a very fast dark relaxation, and requiring an external electric field).

Photochromic and photodichroic polymers that undergo change in isomer state after two-photon absorption are also the subject of extensive study. These materials are reversible and relatively fast (msec); however, disadvantages typically include relatively very fast dark relaxation, short dark storage time and the requirement of coherent UV light sources. Organic polymers are also limited in having relatively low light intensity thresholds due to possible overheating (resulting in chemical decomposition).

Until recently, chalcogenide glasses, which have found application in today's CD and DVD technology 2D data storage materials, have attracted little attention as potential materials for holographic data storage, and have been mainly of academic interest.

The term chalcogenide glasses defines a large family of vitreous materials fabricated from metals (e.g. As, Ge, Sb) in conjunction with the heavier elements in the oxygen family (i.e., the chalcogens S, Se, Te). There are many of such glass-forming chalcogenide compositions. Generally speaking, chalcogenide glasses have low glass transition temperatures (typically 180° - 300°C.) and high refractive indices (typically 2.5). While dependent on composition, the transparency range of these glasses spans (roughly) the 0.8 to 15 micron region.

One of the unique features of chalcogenide glasses is their ability to undergo reversible changes in their optical properties under the action of bandgap illumination as described in K. Shimakawa, A. Kolobov and S.R Elliott, photoinduced effected and metastability in amorphous semiconductors and insulators, Advances in Physics 44, (1995), 475. There are five basic principles utilized in chalcogenide glasses which are used for holographic writing: photodarkening, the change of refractive index and absorption coefficient upon absorption of unpolarized light; photoinduced anisotropy, the change of refractive index absorption coefficient upon absorption of polarized light; relaxational structural changes, the photoinduced expansion and contraction of the glassy matrix; wet etching of the exposed areas of the chalcogenide glass in solvents; and photodoping of chalcogenides with materials which are in direct contact with illuminated area of the sample (such as silver, copper etc.)

Scalar photodarkening (i.e. a photoinduced change in optical properties independent of the polarization of the inducing light) is a well studied optical property in chalcogenide glasses and is believed in the related art to be caused by one or more combinations of the following processes: atomic bond scission, change in atomic distances or bond-angle distribution, or photoinduced chemical reactions such as

$$2As_2S_3 \leftrightarrow 2S + As_4S_4$$

$$\text{amorphous-}As_2S_3 \leftrightarrow \text{crystalline } As_2S_3.$$

The accompanying change in refractive index due to photodarkening is typically greater than that in photorefractive crystals or polymers and can reach up to n - 0.1-0.2 (for comparison Fe-doped $LiNbO_3$ ferroelectric crystals has n - $10^{-4}$). In the early 1970's reversible photoinduced shifts of the optical absorption of vitreous $As_2S_3$ films were reported and used for hologram storage in these materials. Typical diffraction efficiencies of several percent for exposure with 15mW laser power (Ar-ion laser) in 10 sec, with stable dark data storage over 2,500 hours, were reported in $As_2S_3$ films. Similar parameters of diffraction efficiency of holographically written gratings or other holographic elements based on the principle of photodarkening in chalcogenide glasses were later reported by various researchers. An important observation with respect to the present was given in [A. Singh, R.A. Lessard and M. Samson, Effect of temperature on diffraction efficiency of holograms recorded in arsenic trisulphide thin films, Optica Acta 31 (1984) 116], where the diffraction efficiency of holographic gratings was shown to decrease dramatically as the temperature reaches 150°C. The conclusion is that $As_2S_3$ is unsuitable for optical storage at temperatures above 100°C. Heating the samples to the glass-softening temperature is nowadays used to erase the induced photodarkening [Shimakawa et al.]

Photoinduced anisotropy, optical changes under illumination with polarized light (i.e. optically induced birefringence and dichroism), are the second group of optical properties in chalcogenide glasses used for hologram writing. Optical properties such as optically-induced dichroism (anisotropy in absorption) or birefringence (anisotropy in refraction) have been investigated in a variety of chalcogenide materials, in both amorphous thin-film and bulk-glass forms. These investigations led to the invention of materials suitable as a new medium for holographic data storage. A change of refractive index of about ~$3.10^{-3}$ in a-$As_2S_3$ films was first observed in 1977 by Zhdanov and Malinovsky, and nearly 100 research papers have been published on the subject since. The structural changes associated with photoinduced anisotropy are the subject of speculations; however, it is generally accepted that the structural origin of the photoinduced anisotropy is different in nature from that of scalar photodarkening. Reorientation of charged atomic defects, orientation of crystalline units in the glassy matrix and change in bond-angle distributions are all being equally considered as the origin of photoinduced anisotropy. The first holographic recording in chalcogenide glasses [see Ozols et al. holographic recording in amorphous semiconductor films. SPIE 2968 (1997) 282] utilizing photoinduced anisotropy was performed by Kwak at al. The maximum diffraction efficiency (~ 0.2%) with an Ar-ion laser beam (514 nm) and 50mW/cm² light intensity, was reached in order of tens of seconds in [C.H. Kwak, J.T. Kim and S.S. Lee, Scalar and vector holographic gratings recorded in a photoanisotropic amorphous $As_2S_3$ thin films, Optics Lett. 13 (1988) 437]. The effect is essentially reversible by changing the orientation of linearly polarized light to the orthogonal direction to that of the inducing beam. Similar characteristic performances of holographic writing of diffraction elements (diffraction efficiency of order < 5%) with polarized light have been reported later; however, the area of study of vectoral photoinduced anisotropy in chalcogenide glasses is still relatively undeveloped.

Similarly to the scalar changes, the potential use of vectoral anisotropy for holographic data recording suffers from the thermodynamic instability of chalcogenide glasses, where relaxational changes over long storage time at ambient or increased temperatures, or the -inflicted damage during the readout periods, typically decrease the efficiency of the holograms to an unacceptable level.

Relaxational structural changes, a considerable change in viscosity and volume (expansion) of the glassy matrix, have been observed and used for holographic recording as a surface relief pattern on the glassy matrix. The created surface relief pattern is stable and can be stored over an extended time period. The diffraction efficiency of such holographic elements can reach several percent (with the amplitude of the surface relief pattern being a few tens of nanometers); however, as the observed changes are typically surface related, and are only partly reversible (with the maximum diffraction efficiency being achieved with virgin, previously illuminated samples), this method is generally unsuitable for holographic data recording.

For completeness, wet etching of photo-induced holograms in chalcogenide glasses utilizes the feature of chalogenide glass to act as an effective inorganic photoresist, where illuminated or unilluminated areas of the sample are vulnerable to solvents (both positive and negative acting solvents being used). This effect has the potential for use in making holographic master elements for polymer endorsing; however, it is generally unsuitable for holographic data storage, as it requires long times for the development of the recorded data. Photodoping of chalcogenide glasses uses a known feature of chalcogenide glasses to effectively dissolve materials that are in physical contact with illuminated areas of the sample. Although this is potentially interesting in write-only-once type of memories, this effect is generally slow and irreversible, and is not considered preferable for holographic data storage.

Although the above cited recorded holographic elements are often referred to as being stable at room temperature, the long-time thermodynamic instability of some of the chalcogenide glasses clearly hinders these materials from commercialization. As with the majority of the organic-polymeric materials, in chalcogenide glasses also one of the major problems is indeed the temporal fixation of the induced holograms in the material. If this problem were to be overcome, chalcogenides could be used for optical data storage in future optical discs. Karnatovskij et al refer to high-efficiency phase hologram recording in chalcogenide films at elevated temperatures in the Soviet Journal of Quantum Electronics, vol. 7, no. 5, 1980, pages 636 to 638, XP002162550 American Institute of Physics.

It is thus an aim of the present invention to at least partly mitigate the above mentioned problems.

According to a first aspect of the present invention there is provided a holographic recording medium comprising:

an amorphous host material which undergoes a phase change from a first to a second thermodynamic phase in response to a temperature rise above a predetermined transition temperature;
a plurality of photo-sensitive molecular units embedded in the host material and which can be orientated in response to illumination with light from a light source; whereby
said molecular units may be so orientated when said host material is at a temperature equal to or above said transition temperature but retain a substantially fixed orientation at temperatures below said transition temperature;

wherein said molecular units comprise molecular compounds of the type $A_4B_3$ or $A_4B_4$ where A is either phosphorus or arsenic and B is either sulphur, selenium or tellurium.

According to a second aspect of the present invention there is provided a method of forming a holographic element comprising the steps of:

heating an amorphous host material above a predetermined transition temperature at which said material undergoes a thermodynamic phase change from a first to a second thermodynamic state;
selectively illuminating said host material via a light source thereby orienting photo-sensitive molecular units embedded in said host material in response to the illuminating light; and
subsequently cooling said host material below said transition temperature to a temperature at which said host material is in said first thermodynamic state thereby substantially fixing the orientation of said molecular units;

wherein said molecular units comprise molecular compounds of the type $A_4B_3$ or $A_4B_4$ where A is either phosphorus or arsenic and B is either sulphur, selenium or tellurium.

Embodiments of the present invention will now be described hereinafter by way of example only and with reference to the accompanying drawings in which:

Figure 1 shows a comparison of diffraction patterns.

Figure 2 shows a typical behavior for an $As_4Se_3$ film upon illumination with linearly polarized light.

Figure 3 shows details of photoinduced anisotropy.

Figure 4 shows an optical system.

Figure 5 shows a set of interference patterns.

In the drawings like reference numerals refer to like parts.

Embodiments of the present invention are directed to providing new photorefractive materials for holographic recording that are not subject to the above-discussed shortcomings of the prior art, such as volatile readout (erasure on readout), short dark-storage time, irreversibility or need for costly light sources.

In one aspect of the present invention, a holographic storage medium comprises a heat medium which contains molecular cluster compounds of the type $A_4B_3$ or $A_4B_4$ (A = P, As) and B=S, Se, Te) embedded in a host material. The requirement of the host material is to provide a suitable environment for the molecular units, and can be composed of either an amorphous inorganic solid network comprising of either the same constituent atoms as in the molecular units or a combination of different atoms forming an amorphous inorganic structure and/or an organic-polymer phase.

When an interference pattern is formed within this medium by means of illumination with coherent linearly polarized light, in the light areas of this interference pattern the molecular units orient themselves with respect to the electric-field vector of the linearly polarized light, thereby causing a preferential overall redistribution of refractive index in the illuminated areas, forming a volume phase hologram and other holographic elements within the medium.

As is well known and understood in the holographic art, volume phase holograms record information as a modulation of the refractive index of the medium in which the recording is effected. In practising the present invention, a considerable modulation of the molecular refractive index can be caused in a glassy-crystalline material containing molecular compounds of the type $A_4B_3$ or $A_4B_4$ (A = P. As) and (B=S, Se, Te). These materials can be prepared in various methods well known in solid-state physics and chemistry art. In our example, the inorganic glassy-crystalline material can be prepared via thermal evaporation of a melt of As and Se elements with a respective molar ratio of 4:3. Evaporation of the melt onto a silica substrate in high vacuum with an evaporation rate of 1-3nm per second causes a material consisting of an amorphous network with embedded molecular units of $As_4Se_3$ to be prepared. The concentration of the molecular-unit phase is dependent on conditions such as temperature of the melt, temperature of the substrate, molar ratio of the elements in the melt, rate of evaporation, temperature treatment of the created film etc. and need not be specified further. It is envisaged that for preparation of the holographic medium, various methods of preparation can be employed, for example spin coating of chemical vapour deposition (CVD); or extraction of the molecular units and consequent blending into a polymer phase. Similar glassy-crystal compositions can also be prepared with a combination of different elements than arsenic and selenium, such as arsenic and sulfur, phosphorus and sulfur, or phosphorus and selenium to form molecular units similar to those of $As_4Se_3$ and $As_4Se_4$.

Investigation has shown that it is possible, repeatedly and reversibly, or permanently if desired, to reorient and align these molecular units under illumination with linearly polarized light. Desirable changes in the optical properties/holographic performance may be effected in this manner, since small differences between the refractive index or optical density of the area with aligned molecular units alone and also that of aligned molecular units and host medium are amplified in their effect on the optical properties of the combination.

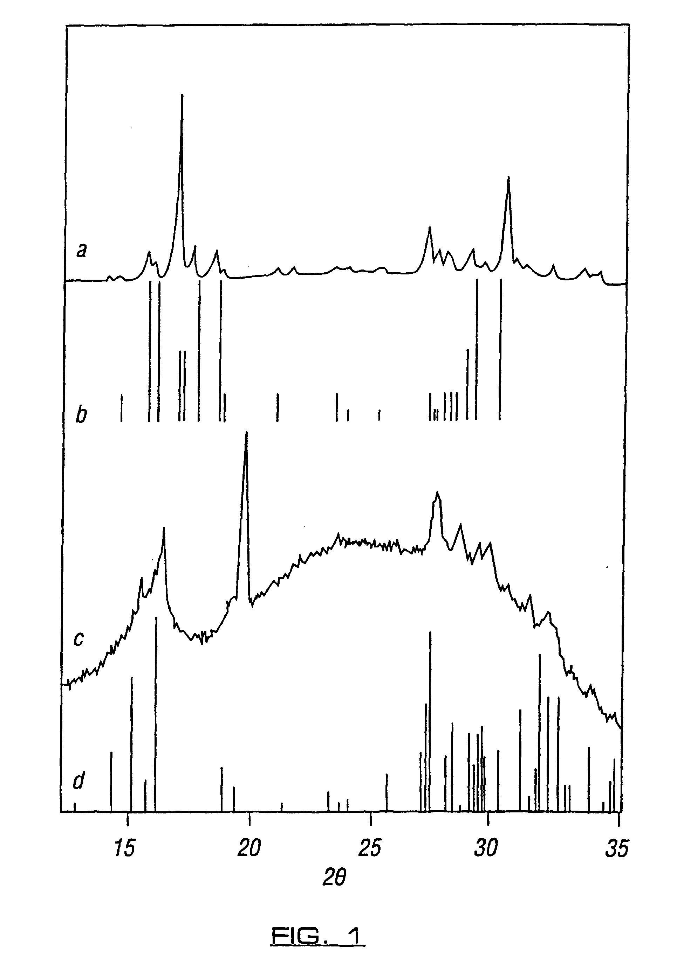

According to a first embodiment of the present invention a holographic element of composition $As_4Se_3$ may be prepared by thermal evaporation of a melt of As and Se, in the molar ratio 4:3. Details of the thermal behavior of these $A_4B_3$ cage molecules [A=P, As, B=S, Se] is described in [R. Blachnik and U. Wickel, Thermal behavior of A4B3 cage molecules (A=P, As;B=S, Se, Thermochimica Acta 81 (1984) 185]. The rate of evaporation was 1-3nm per second and the resulting film was 1μm thick. Analysis of the X-ray diffraction spectrum of the $As_4Se_3$ film Figure 1(a), showed essentially the same diffraction pattern as a similar material processed by vacuum sublimation and extraction of the product with $CS_2$, which is believed to be representative of $\alpha$-$As_4Se_3$ molecular crystals shown in Figure 1 (b) (Blachnik R. and Wickel U., Thermochimica Acta, 81 (1984), 185-196). Details of the data shown in Figure 1 are set out in more detail below. Figure 1 shows comparison of X-ray ($CuK_\alpha$) diffraction patterns of: (a) as-evaporated 1 μm thick $As_4Se_3$ film; (b) crystalline $\alpha$-$As_4Se_3$ prepared by vacuum sublimation and extraction in $CS_2$ (the peak intensities were estimated from X-ray photographs) (Blachnik and Wickel (1984); (c) diffraction pattern of 1 μm thick $As_4Se_3$ film annealed for several hours at temperatures around 350K; (d) X-ray diffractogram of monoclinic c-$As_4Se_3$ (after Smail E.J. and Sheldrick G. M., (1973) Acta Crystallogr. B29, 2014).

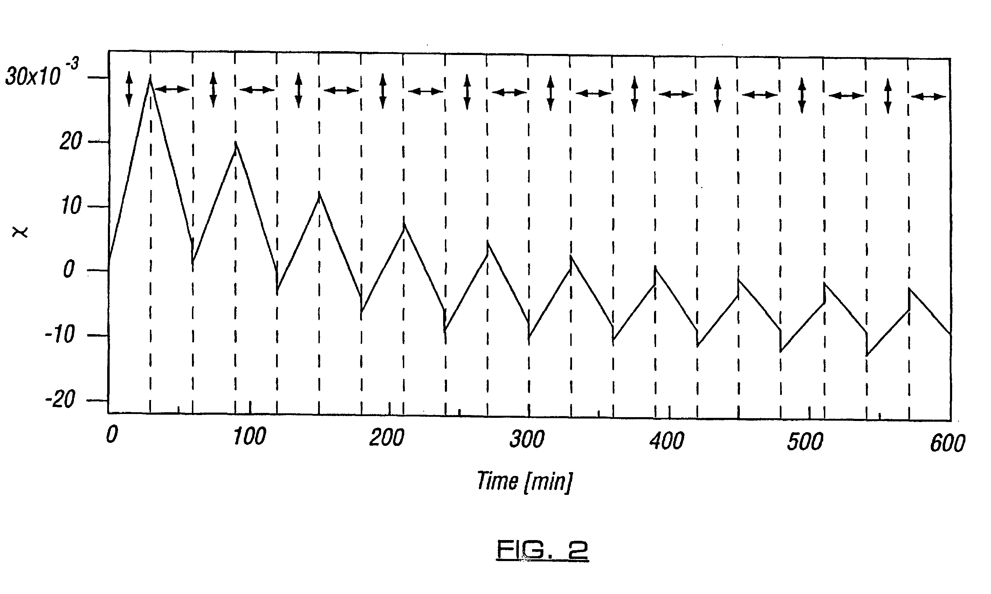

Processing of the said holographic element by exposure to linearly polarized light modulates the index of refraction with respect to the electric vector of the inducing linearly polarized light. He-Ne laser light (633nm, 100mW/cm$^2$) is one source of such polarized light although other forms can be used as is known in the art. Fig. 2 shows the modulation of the absorption coefficients $\alpha_{||}$ and $\alpha\perp$ in a virgin $As_4Se_3$ film in several consecutive cycles in which the electric vector of the inducing light was oriented in two, mutually orthogonal directions during the experiment (denoted by arrows in Figure 2). $\alpha_{||}$ and $\alpha_{\perp}$ are the absorption coefficients of the illuminated sample in the direction parallel (II) and orthogonal ($\perp$) to the electric vector of inducing linearly polarized light respectively. The induced modulation of the absorption coefficient is shown as a ratio of the transmitted light intensities:

$$\chi = 2(I_{||}-I\perp)/(I_{||}+I\perp) \sim (I_{||}+I\perp)$$

$I_{||}$ is the intensity of the transmitted light of the originally linearly polarized He-Ne laser light used for aligning and reorienting the molecular units, and $I\perp$ is the transmitted intensity of the linearly polarized He-Ne laser with the polarization vector orthogonal to the said molecular-unit aligning and reorienting He-Ne laser light. This was used to probe the holographic element at discrete short time intervals, i.e. to probe the amount of the alignment and reorientation of the molecular units. It is well known and understood in optical art that the transmission intensity measurement is directly related to the change of the index of refraction by the Kramers-Kronig relationship. Hence, figure 2 also directly shows modulation of the refractive index in the material. The results show the typical behavior of a virgin 1 μm thick $As_4Se_3$ film upon illumination with linearly polarized light. The time interval between the polarization changes is 30 minutes.

When the orientation of the electric vector of the said aligning and reorientating laser is changed to the orthogonal direction (denoted by arrows between the grid lines in figure 2), the amount of the alignment and orientation of the molecular units, given by the ratio $\chi$, with respect to previous laser illumination can be changed to zero and even reorientation of the molecular units can be further continued to the direction on average orthogonal to the previous one. Such cycles of orientation and erasure can be repeated several times at ambient temperature.

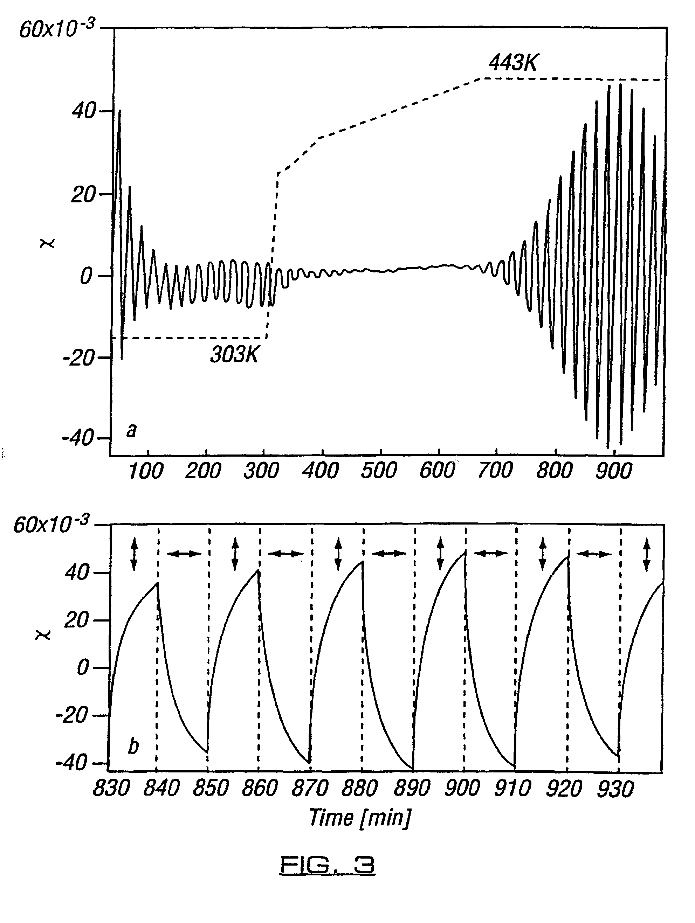

The holographic element used in the above was subjected to increased temperature. It is known in related art that, at increased temperatures, caused either by external heating or directly by absorption of light, crystals consisting entirely of the said $A_4B_3$ or $A_4B_4$ molecules transform into the plastically crystal-like state. The intermolecular forces in the plastic phase are weakened in such a way that it is believed that $A_4B_3$ or $A_4B_4$ molecules can be relatively freely oriented within the medium under the influence of an external field of typically thermal or mechanical origin. It has now been found that it is possible, repeatedly and reversibly, or permanently if desired, directionally to orient and align the molecules in such a plastic phase by illumination with polarized light. This preferential reorientation of the molecular units can be preserved in the glass after cooling the holographic medium to temperatures below the temperature associated with the plastic-phase change of the molecules. Hence, preferential orientation of the optical axes due to the rotation of the molecules at temperatures of plastic phase formation resulting in a specific index of refraction can be preserved in the said holographic element. Figure 3(a) illustrates typical kinetics of photo-induced anisotropy at the plastic-phase-change transition temperature for an $As_4Se_3$ sample with a He-Ne linearly polarized laser ($\lambda$ = 632.8nm, and with the intensity of the inducing light $\sim$ 50-100mW/

$cm^2$). The temperature was increased from ambient (303K) to the plastic-phase-change temperature by external heating of the sample (see temperature profile given by dotted line in (a)). Figure 3(b) shows a detail of the photoinduced anisotropy at the plastic-phase-change temperature. The polarization was changed on the grid lines. Relative orientation of the electric vector of the inducing light is denoted by arrows. Note a significant increase of the time response in comparison with Fig. 2. Figure 3(a) in more detail shows typical kinetics of the said transmitted light intensity ratio $\chi$ in a 1 μm thick $As_4Se_3$ film while heated from ambient temperature to a temperature around 443K at which $As_4Se_3$ transforms into a plastically crystalline modification. A significant increase of the photoinduced anisotropy ($\chi$) amplitude, along with a shorter time needed for reorientation and alignment of the molecules, can be discerned from Figure 3(b) upon comparison with Figure 2. Comparison of the X-ray diffraction pattern of the $As_4Se_3$ material after several hours of annealing at about 400K (see Figure 1(c)) with the X-ray diffractogram of monoclinic c-$As_4Se_3$ believed to be composed of the molecular units $As_4Se_3$ (Figure 1(d)), shows a considerable transformation of the original dominant $As_4Se_3$ molecular units (Figure 1(a)) of the as-prepared $As_4Se_3$ film into $As_4Se_3$ molecules.

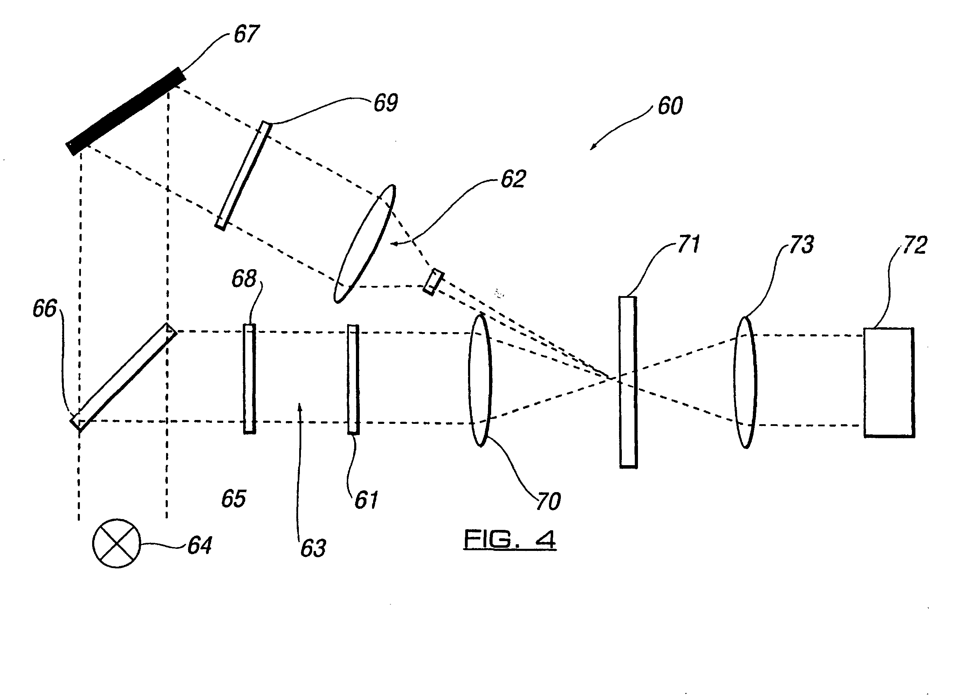

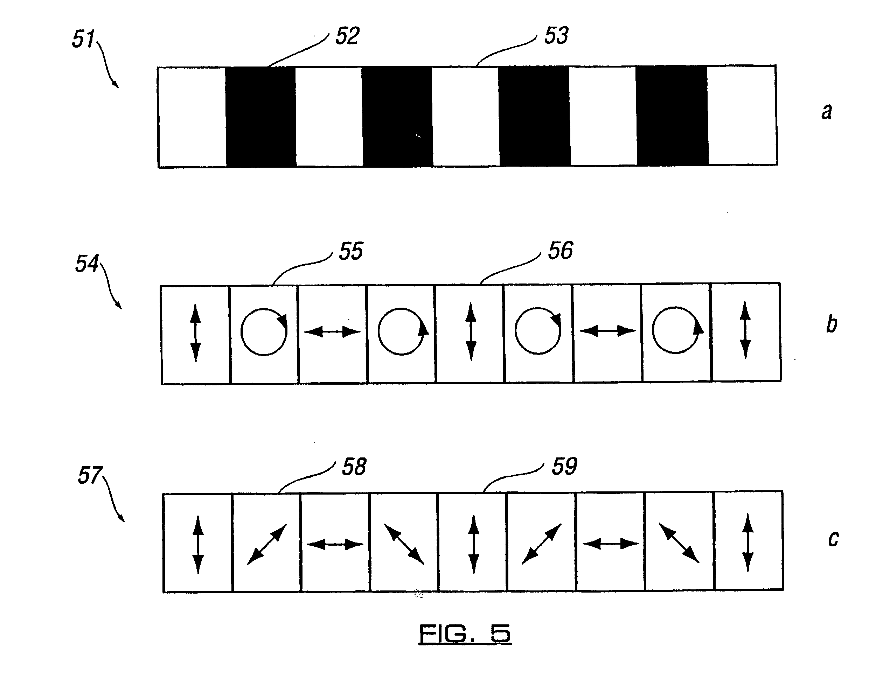

Figure 4 illustrates one arrangement of optical devices which may be used to provide the ability to "write" data in the form of holographic images in a recording medium according to an embodiment of the present invention. Reference will be first made to figure 5a, 5b and 5c to help explain how various forms of holographic patterns can be formed.

The principle of holography lies in the interference of two coherent light beams, one called a reference beam and a second called the object beam. If both beams are linearly polarized, equivalent in amplitude (intensity) and phase (polarization) and are incident on a sample under a certain angle they form so called holographic gratings. The light intensity distribution 51 in such gratings is dependent on wavelength of the light and angle of incidence and is a sinusoidal function of alternating dark 52 and bright 53 areas shown in figure 5a.

If, however, one of the linearly polarized beam is phase shifted relative to the other so that, for example, the polarization angle of a beam is orthogonal to the second beam, these two beams still form a diffraction grating upon interference on the substrate, but this is not an intensity grating as in the first example, but rather a phase grating 54. That is, there will not be lighter and darker "lines" of interfering light. In fact the intensity distribution will be at a constant value; what will change, however, is the phase distribution. If two linearly polarized beams have their polarization axes orthogonal to each other they will interfere on the substrate; the resulting pattern will consist of alternating areas shown in figure 5b consisting of regions of circularly polarized light 55 and regions of linearly polarized light 56. The regions of circularly polarized light vary from regions of left hand circularly polarized light to regions of right hand circularly polarized light (as indicated by the arrows). The figure shows extreme cases; of course, in the boundaries there is generally elliptically polarized light.

However, in the case of two interfering beams being circularly polarized, one right handed and the second left handed, the interference pattern will again have the same intensity, but the phase of the pattern will look like that of figure 5c which shows the interference pattern 57 resulting in two types of regions of linearly polarized light.

The last two examples 54 and 57 are called in the holographic art "polarization holography". In order to be able to write phase patterns, one needs a medium which is sensitive to the phase of light. Most of the media are sensitive only to amplitude (such as silver halides (photographic emulsions), lithium niobate or most polymers). Some, however, are sensitive to phase (polarization) as well. For example, some photorefractive polymers or the chalcogenide glasses (the material of interest). Phase holograms are more efficient compared to amplitude holograms (i.e. sensitive to light intensity). Embodiments of the present invention can use any of these types of holography.

If a beam strikes an object, it gets reflected; in principle, the amplitude as well as phase of the light from the object is changed. Normal photographic emulsion records only amplitude changes, so one ends up with a very "flat" information content. However, if this light beam (the object beam) is allowed to interfere with a second "reference" beam, it ends up in a general light-intensity variation on the sample. If the sample is capable of recording intensity variations a very realistic image of an object can be recorded and replayed back by illumination of the sample with a reference beam only. This is the broad principle behind holographic data storage and holography as such.

Figure 4 shows a possible set-up for a holographic recording or reading apparatus. The apparatus 60 uses a spatial light modulator (SLM) 61 which can be an object with a well-defined data stream by means of light and dark dots (for example, a transmitting liquid-crystal display or micromirror device). Figure 4 shows two beams, reference beam 62 and an object beam 63. These are formed as a first beam from a source of coherent light 64(such as a laser) being split. Light from the light source 64 pass through a beamsplitter 66 which divides the beam into two equal parts. Parts of the beams are undeviated and are subsequently reflected by mirror 67 to form the reference beam 62 whilst the other part is reflected sideways into waveplate 68 to form the object beam 63 thereafter both are being treated individually. There is likewise another waveplate 69. As light strikes the waveplates the phase of light changes accordingly. In the case where the two waveplates are $\lambda/2$ waveplates and properly aligned, one can end up at certain orientations of the $\lambda/2$ waveplates with an upper part of the beam having the polarization vector linearly polarized orthogonal with respect to the bottom part of the beam - this would give an interference pattern shown in Fig. Sa. In the case where the two waveplates are $\lambda/4$ waveplates and properly aligned, one can end up at certain orientations of the $\lambda/4$ waveplates with an upper part of the beam having polarization vector, say, left hand circularly polarized with respect to the bottom part of the beam. The bottom part of the initially linearly polarized beam can be aligned by the $\lambda/4$ waveplate to give a right hand circularly polarized beam - this would give an interference pattern as shown in Fig. 5b.

So after the bottom part of the beam passes through the SLM 61 and is "Fourier transformed", i.e., focused by the lens 70 on the substrate or sample 71, one can write an interference pattern which can subsequently be read by a reference beam on a CCD or CMOS camera 72 suitably focused by lens 73. One can now move the sample and record another spot. This can be done either by moving to a completely different spot or using a phase mask. One can in principle write several holograms into "nearly" the same spot - so called phase-multiplexing.

In this way an interference pattern can be formed in the sample 71. If the temperature of this sample is controlled as hereindescribed, molecular units embedded in the sample can be selectively orientated. If the sample is then cooled it can be removed but will retain the interference information since the molecular units will have a relatively fixed orientation. This will hold a record of the information input by means of the SLM and can subsequently be read out via a similar apparatus.

The much slower reorientation mobility of the aligned molecular units at ambient temperatures allows long-time, or permanent, data storage in this material. Long-time storage of such high-temperature induced anisotropy has been observed at room temperature for an extended period of several weeks and the effects are stable within the limits required (as data storage for 2 or more years).

Embodiments of the present invention thus provide a holographic recording medium and method of forming thereof, which comprises (a) molecular units capable of alignment and orientation under the influence of polarized laser light and (b) a host medium in the form of an amorphous inorganic glassy network or an organic polymer in which the molecular units are embedded. It will be understood that the invention is not limited to these embodiments.

When an interference pattern is formed within this medium by means of illumination with polarized light, in the light areas of this interference pattern the molecular units orientate themselves with respect to the electric-field vector of the linearly polarized light, thereby causing a preferential redistribution of spatial orientation of the molecular units in the previously homogeneous medium and the formation of a volume hologram within the medium. The magnitude and speed of this response to polarized light is greatly enhanced by illuminating the chalcogenide film at elevated temperatures; subsequent cooling to ambient temperatures freezes in this giant response to thereby fix the molecular units in orientation.

Certain embodiments of the present invention provide the added advantage over competing holographic-storage media that it can store polarized holograms. This material is, in one preferred embodiment, a chalcogenide glass containing molecular clusters which, under certain processing conditions: e.g. illumination at elevated temperatures, followed by rapid cooling to ambient temperatures, can have induced within it large values of dichroism and birefringence following illumination with polarized light.

One of the materials that has been identified as a hologram storage medium is an As-Se chalcogenide alloy containing $As_4Se_3$ molecules dispersed in a glassy matrix. It is believed that the action of the polarized light, in inducing dichroism or birefringence, is to rotate these dipolar molecules in the matrix in a direction determined by the electric vector of the polarized light. One of the reasons for believing this is that materials containing a smaller concentration of $As_4Se_3$ molecules exhibit a smaller value of saturated dichroism.

A very sensitive probe of cluster molecules, such as $As_4Se_3$, is Raman spectroscopy in which the narrow-band vibrational spectra are much more highly resolved than the broad bands typical of the host amorphous matrix and this may therefore be used to investigate the local structure of the chalcogenide film containing a stored hologram (for simplicity, for example a grating produced by two non-collinear, interfering laser beams). The Raman spectrum may be investigated in spatial regions of the material containing respectively maxima and minima in the stored interference pattern. The polarized nature of the stored "hologram" may be useful in distinguishing aligned from non-aligned regions. A variety of materials may also contain optically-active, rotatable cluster molecules. Changes in the polarized (HH, HV) broad Raman band characteristic of the host amorphous matrix may be investigated to detect any optically anisotropic changes that may be induced in it. Temperature effects may also be examined.

It is currently (but without limitation) believed that, in the case of As-Se glasses, $As_4Se_3$ molecules provide the optimum optical element. In the case of films made by thermal evaporation, the concentration of optically active $As_4Se_3$ molecules depends on a number of parameters, e.g. temperature of the evaporation boat, rate of evaporation, substrate temperature, etc. Optimization of film properties may be addressed by changing evaporation conditions and/or other preparation conditions.

Another, novel approach is to extract and separate the optically-active cluster molecules from a bulk glass, e.g. by dissolution in suitable solvents. Such molecules could then be dispersed, at a chosen concentration, in a suitable solid matrix. Such a matrix might be a chalcogenide glass of similar (or different) composition or even a polymeric material. Films of such cluster-matrix composites could then be fabricated, for example, by spin-coating. Another approach would be to synthesise dipolar organic cluster molecules, perhaps dispersed in an organic matrix, as the basis for rewriteable, polarized holographic storage media.

The storage medium may be encapsulated. Encapsulation of the optically-active film by a transparent layer is greatly preferred, to prevent irreversible damage resulting from thermo oxidation or evaporation of the chalcogenide (or other) active layer when the storage medium is heat-treated. Furthermore, this encapsulant film could form a non-reflective coating for the read-write laser wavelength, thereby improving the diffraction efficiency. Different types of encapsulant material may give preferred features, including inertness, and film integrity.

The further optimization of holographic data storage in cluster-containing chalcogenide (and other) materials may involve write-speed, thermal and temporal stability of stored holograms, erasure efficiency, storage density noise sources and bit-error rate.

Another novel aspect of the new molecular-cluster holographic storage media is that they can store polarized holograms formed using polarized light sources, unlike competing materials such as $LiNbO_3$, or polymers which can only store scalar (unpolarized) holograms. Moreover, at least at room temperature where the effect has already been studied, the photoinduced anisotropy can be reversibly erased and rewritten in an orthogonal polarization for very many cycles without fatigue. The same reversibility and lack of fatigue may be observed for high-temperature illumination, especially if samples are sufficiently well encapsulated to preclude irreversible damage (e.g. evaporation, oxidation, etc.). It has been demonstrated that the anisotropy can be rewritten for orthogonal polarizations at high temperatures. The ability to store polarized holograms opens up several novel avenues of research. For instance, in principle, it should allow an appreciable increase in storage density over scalar hologram storage.

This technology would greatly increase data-storage densities and information-retrieval rates compared with present technologies. Thus, existing IT technologies would be enhanced, and other new applications could be envisaged, particularly relating to data communication by optic fibre which has sufficient bandwidth to cope with the Gbit-sec data-retrieval rates achievable with holographic data storage. An example might be video on demand.

It will be understood that heating of the medium to near or above the temperature of the plastic phase change can be provided either externally or in one step by absorption of the polarized light (or electromagnetic radiation of a different wavelength) or in any other suitable way.

It will also be understood that holograms according to this invention may be created by lasers having a wide range of energies, ranging from ultraviolet to near-infrared light of different optical power, depending on the bandgap of the material. Likewise pulsed or continuous powers lasers may be utilized.

It will likewise be understood that the holograms resulting from this invention may be incorporated into other optical structures. In addition, the holograms can be surface coated with a clean transparent polymer or similar protective organic or inorganic material which will mechanically protect and prevent surface deterioration of the hologram element.

It will further be understood that a considerable decrease of the time response of the phenomena at temperatures under which the material undergoes the plastic-phase change may be achieved by increasing the light power density of the linearly polarized inducing beam.

It will also be understood that reorientation of the molecular units, and hence the modulation in refractive index, can also be utilized for two-dimensional type optical memories (i.e. CD and DVD) by illumination of an $As_4Se_3$-containing medium by highly focused beams of non-coherent linearly polarized light to give a 2D array of recorded bits in a given layer.

While the invention has been described in detail and with reference to specific embodiments thereof, it will be apparent to those skilled in the art that various changes can be made without departing from the scope of the invention.

**Claims**

1. A holographic recording medium comprising:

an amorphous host material (71) which undergoes a phase change from a first to a second thermodynamic phase in response to a temperature rise above a predetermined transition temperature;
a plurality of photo-sensitive molecular units embedded in the host material (71) and which can be orientated in response to illumination with light from a light source (64); whereby said molecular units may be so orientated when said host material (71) is at a temperature equal to or above said transition temperature but retain a substantially fixed orientation at temperatures below said transition temperature;

wherein said molecular units comprise molecular compounds of the type $A_4B_3$ or $A_4B_4$ where A is either phosphorus or arsenic and B is either sulphur, selenium or tellurium.

2. The recording medium as claimed in claim 1 wherein said host material (71) comprises an inorganic glassy matrix material.

3. The recording medium as claimed in claim 1 wherein said host material (71) comprises an inorganic crystalline matrix material.

4. The recording medium as claimed in claim 1 wherein said host material (71) comprises a chalcogenide glass.

5. The recording medium as claimed in any preceding claim wherein each of said molecular units comprises a generally spherical molecule having a dipole moment.

6. The recording medium as claimed in claim 5 wherein said dipole moment can interact with an electric field vector associated with said light source (64) to cause an orientation of a respective molecular unit.

7. The recording medium as claimed in any preceding claim wherein the orientation of molecular units in selected regions of said host material (71) provides a photoinduced anisotropic response.

8. The recording medium as claimed in any preceding claim wherein:

regions of said host material (71) in which said molecular units are commonly orientated have a different index of refraction than regions of said host material in which said molecular units are not so commonly orientated.

9. The recording medium as claimed in any of claims 1 to 7 wherein:

regions of said host material (71) in which said molecular units are commonly orientated have a different index of absorption than regions of said host material in which said molecular units are not so commonly orientated.

10. The recording medium as claimed in any preceding claim wherein said molecular units comprise a semiconductor material.

11. The recording medium as claimed in any preceding claim, wherein said molecular units comprise a thin film deposited on said host material.

12. The recording medium as claimed in any preceding claims further comprising:

an encapsulant comprising a transparent protective layer substantially covering the surface of said recording medium.

13. A method of forming a holographic element comprising the steps of:

heating an amorphous host material (71) above a predetermined transition temperature at which said material undergoes a thermodynamic phase change from a first to a second thermodynamic state;
selectively illuminating said host material via a light source (64) thereby orienting photo-sensitive molecular units embedded in said host material (71) in response to the illuminating light; and
subsequently cooling said host material (71) below said transition temperature to a temperature at which said host material (71) is in said first thermodynamic state thereby substantially fixing the orientation of said molecular units;

wherein said molecular units comprise molecular compounds of the type $A_4B_3$ or $A_4B_4$ where A is either phosphorus or arsenic and B is either sulphur, selenium or tellurium.

14. The method as claimed in claim 13 wherein said host material (71) comprises an inorganic glassy matrix material.

15. The method as claimed in claim 13 wherein:

said host material (71) comprises an inorganic crystalline matrix material.

16. The method as claimed in claim 13 wherein said host material (71) comprises a chalcogenide glass.

17. The method as claimed in any of claims 13 to 16 wherein said orientating step comprises illuminating the host material (71) with polarized light.

18. The method as claimed in any of claims 13 to 17 wherein said light source (64) comprises a source of linearly polarized light.

19. The method as claimed in claim 18 wherein said light source (64) comprises a laser.

20. The method as claimed in any of claims 13 to 16 wherein said light source (64) comprises a source of circularly polarized light.

21. The method as claimed in any of claims 13 to 20 further comprising the steps of:

varying the index of refraction in regions of said host material (71) where said molecular units are commonly orientated compared to the index of refraction in regions of said host material (71) which are not so orientated.

22. The method as claimed in any of claims 13 to 20 further comprising the steps of:

varying the index of absorption in regions of said host material (71) where said molecular units are commonly orientated compared to the index of absorption in regions of said host material which are not so orientated.

23. The method as claimed in any of claims 13 to 22 wherein said host material (71) is heated by external heating.

24. The method as claimed in any of claims 13 to 22 wherein said host material (71) is heated by absorption of polarized laser light.

25. The method as claimed in any of claims 13 to 24 wherein said first thermodynamic state comprises the solid state.

26. The method as claimed in any of claims 13 to 25 wherein said second thermodynamic state comprises a plastic-like state.

27. The method as claimed in any of claims 13 to 26 wherein said host material (71) is substantially solid at room temperature.

28. The method as claimed in any of claims 13 to 22 wherein said step of orientating molecular units comprises, for each unit, aligning a dipole moment associated with the molecular unit with the electric vector associated with the illuminating light.

29. The method as claimed in any of claims 13 to 28 further comprising the steps of:

reversibly orientating said molecular units.

30. The method as claimed in any of claims 13 to 29 further comprising the steps of:

reheating the host material (71) above said predetermined transition temperature;
reorientating molecular units via a light source (64); and
cooling said host material (71) below said predetermined transition temperature.

**Patentansprüche**

1. Holographisches Aufzeichnungsmedium mit:

einem amorphen Wirtsmaterial (71), das nach Maßgabe eines Temperaturanstiegs über eine vorbestimmte Umwandlungstemperatur eine Phasenänderung von einer ersten zu einer zweiten thermodynamischen Phase erfährt; eine Vielzahl von lichtempfindlichen Moleküleinheiten, die in das Wirtsmaterial (71) eingebettet sind und nach Maßgabe der Beleuchtung mit Licht von einer Lichtquelle (64) ausgerichtet werden können; wodurch die Moleküleinheiten so ausgerichtet werden können, wenn sich das Wirtsmaterial (71) auf einer Temperatur befindet, die gleich der oder höher als die Umwandlungstemperatur ist, jedoch bei Temperaturen unter der Umwandlungstemperatur eine im wesentlichen feste Ausrichtung beibehalten;

wobei die Moleküleinheiten Molekülverbindungen der Art $A_4B_3$ oder $A_4B_4$ umfassen, wobei A entweder Phosphor oder Arsen ist und B entweder Schwefel, Selen oder Tellur ist.

2. Aufzeichnungsmedium nach Anspruch 1, wobei das Wirtsmaterial (71) ein anorganisches glasartiges Matrixmaterial umfaßt.

3. Aufzeichnungsmedium nach Anspruch 1, wobei das Wirtsmaterial (71) ein anorganisches kristallines Matrixmaterial umfaßt.

4. Aufzeichnungsmedium nach Anspruch 1, wobei das Wirtsmaterial (71) ein Chalcogenidglas umfaßt.

5. Aufzeichnungsmedium nach einem vorhergehenden Anspruch, wobei jede der Moleküleinheiten ein im allgemeinen kugelförmiges Molekül mit einem Dipolmoment umfaßt.

6. Aufzeichnungsmedium nach Anspruch 5, wobei das Dipolmoment mit einem der Lichtquelle (64) zugeordneten elektrischen Feldvektor zusammenwirken kann, um eine Ausrichtung einer jeweiligen Moleküleinheit zu bewirken.

7. Aufzeichnungsmedium nach einem vorhergehenden Anspruch, wobei durch die Ausrichtung der Moleküleinheiten in ausgewählten Bereichen des Wirtsmaterials (71) eine durch Licht induzierte anisotrope Reaktion vorgesehen ist.

8. Aufzeichnungsmedium nach einem vorhergehenden Anspruch, wobei:

Bereiche des Wirtsmaterials (71), in denen die Moleküleinheiten in üblicher Weise ausgerichtet sind, einen anderen Brechungsindex als Bereiche des Wirtsmaterials aufweisen, in denen die Moleküleinheiten nicht so in üblicher Weise ausgerichtet sind.

9. Aufzeichnungsmedium nach einem der Ansprüche 1 bis 7, wobei:

Bereiche des Wirtsmaterials (71), in denen die Moleküleinheiten in üblicher Weise ausgerichtet sind, einen anderen Absorptionsindex als Bereiche des Wirtsmaterials aufweisen, in denen die Moleküleinheiten nicht so in üblicher Weise ausgerichtet sind.

10. Aufzeichnungsmedium nach einem vorhergehenden Anspruch, wobei die Moleküleinheiten ein Halbleitermaterial umfassen.

11. Aufzeichnungsmedium nach einem vorhergehenden Anspruch, wobei die Moleküleinheiten eine auf das Wirtsmaterial aufgebrachte Dünnschicht umfassen.

12. Aufzeichnungsmedium nach einem vorhergehenden Anspruch, ferner mit:

einem Einbettmaterial, das eine im wesentlichen die Oberfläche des Aufzeichnungsmediums bedeckende durchsichtige Schutzschicht umfaßt.

13. Verfahren zum Ausbilden eines holographischen Elements mit den folgenden Schritten:

dem Aufheizen eines amorphen Wirtsmaterials (71) über eine vorbestimmte Umwandlungstemperatur, bei der das Material eine thermodynamische Phasenänderung von einem ersten zu einem zweiten thermodynamischen Zustand erfährt; wahlweise dem Beleuchten des Wirtsmaterials über eine Lichtquelle (64) und dadurch dem Ausrichten der in dem Wirtsmaterial (71) eingebetteten Moleküleinheiten nach Maßgabe des Beleuchtungslichts; und anschließend dem Abkühlen des Wirtsmaterials (71) unter die Umwandlungstemperatur auf eine Temperatur, bei der sich das Wirtsmaterial (71) in dem ersten thermodynamischen Zustand befindet, wodurch die Ausrichtung der Moleküleinheiten im wesentlichen fixiert wird;

wobei die Moleküleinheiten Molekülverbindungen der Art $A_4B_3$ oder $A_4B_4$ umfassen, wobei A entweder Phosphor oder Arsen ist und B entweder Schwefel, Selen oder Tellur ist.

14. Verfahren nach Anspruch 13, wobei das Wirtsmaterial (71) ein anorganisches glasartiges Matrixmaterial umfaßt.

**15.** Verfahren nach Anspruch 13, wobei:

das Wirtsmaterial (71) ein anorganisches kristallines Matrixmaterial umfaßt.

**16.** Verfahren nach Anspruch 13, wobei das Wirtsmaterial (71) ein Chalcogenidglas umfaßt.

**17.** Verfahren nach einem der Ansprüche 13 bis 16, wobei der Ausrichtungsschritt das Beleuchten des Wirtsmaterials (71) mit polarisiertem Licht umfaßt.

**18.** Verfahren nach einem der Ansprüche 13 bis 17, wobei die Lichtquelle (64) eine Quelle von linear polarisiertem Licht umfaßt.

**19.** Verfahren nach Anspruch 18, wobei die Lichtquelle (64) einen Laser umfaßt.

**20.** Verfahren nach einem der Ansprüche 13 bis 16, wobei die Lichtquelle (64) eine Quelle von kreisförmig polarisiertem Licht umfaßt.

**21.** Verfahren nach einem der Ansprüche 13 bis 20, ferner mit den folgenden Schritten:

dem Verändern des Brechungsindexes in Bereichen des Wirtsmaterials (71), wo die Moleküleinheiten in üblicher Weise ausgerichtet sind, im Vergleich zu dem Brechungsindex in Bereichen des Wirtsmaterials (71), die nicht so ausgerichtet sind.

**22.** Verfahren nach einem der Ansprüche 13 bis 20, ferner mit den folgenden Schritten:

dem Verändern des Absorptionsindexes in Bereichen des Wirtsmaterials (71), wo die Moleküleinheiten in üblicher Weise ausgerichtet sind, im Vergleich zu dem Absorptionsindex in Bereichen des Wirtsmaterials, die nicht so ausgerichtet sind.

**23.** Verfahren nach einem der Ansprüche 13 bis 22, wobei das Wirtsmaterial (71) durch Beheizung von außen aufgeheizt wird.

**24.** Verfahren nach einem der Ansprüche 13 bis 22, wobei das Wirtsmaterial (71) durch Absorption von polarisiertem Laserlicht aufgeheizt wird.

**25.** Verfahren nach einem der Ansprüche 13 bis 24, wobei der erste thermodynamische Zustand den festen Zustand umfaßt.

**26.** Verfahren nach einem der Ansprüche 13 bis 25, wobei der zweite thermodynamische Zustand einen dem plastischen ähnlichen Zustand umfaßt.

**27.** Verfahren nach einem der Ansprüche 13 bis 26, wobei das Wirtsmaterial (71) bei Zimmertemperatur im wesentlichen fest ist.

**28.** Verfahren nach einem der Ansprüche 13 bis 27, wobei der Schritt des Ausrichtens der Moleküleinheiten bei jeder Einheit das Ausrichten eines der Moleküleinheit zugeordneten Dipolmoments umfaßt, wobei der elektrische Vektor dem Beleuchtungslicht zugeordnet ist.

**29.** Verfahren nach einem der Ansprüche 13 bis 28, ferner mit den folgenden Schritten:

dem reversiblen Ausrichten der Moleküleinheiten.

**30.** Verfahren nach einem der Ansprüche 13 bis 29, ferner mit den folgenden Schritten:

dem Wiederaufheizen des Wirtsmaterials (71) über die vorbestimmte Umwandlungstemperatur;
dem Wiederausrichten der Moleküleinheiten über eine Lichtquelle (64); und
dem Abkühlen des Wirtsmaterials (71) unter die vorbestimmte Umwandlungstemperatur.

**Revendications**

**1.** Support d'enregistrement holographique comprenant :

un matériau hôte (71) amorphe qui subit un changement de phase, depuis une première vers une seconde phase thermodynamique, en réponse à une élévation de température au-dessus d'une température de transition prédéterminée ;
plusieurs unités moléculaires photosensibles enrobées dans le matériau hôte (71), et qui peuvent être orientées en réponse à une illumination avec une lumière émanant d'une source lumineuse (64) ; moyennant quoi
lesdites unités moléculaires peuvent être ainsi orientées lorsque ledit matériau hôte (71) se trouve à une température égale ou supérieure à ladite température de transition, mais maintiennent une orientation sensiblement fixe à des températures situées en dessous de ladite température de transition ;

dans lequel lesdites unités moléculaires comprennent des composés moléculaires du type $A_4B_3$

ou $A_4B_4$ où A est du phosphore ou de l'arsenic et B est du soufre, du sélénium ou du tellure.

**2.** Support d'enregistrement tel que revendiqué dans la revendication 1, dans lequel ledit matériau hôte (71) comprend un matériau de matrice vitreux, inorganique.

**3.** Support d'enregistrement tel que revendiqué dans la revendication 1, dans lequel ledit matériau hôte (71) comprend un matériau de matrice cristallin, inorganique.

**4.** Support d'enregistrement tel que revendiqué dans la revendication 1, dans lequel ledit matériau hôte (71) comprend un verre de chalcogénure.

**5.** Support d'enregistrement tel que revendiqué dans l'une quelconque des revendications précédentes, dans lequel chacune desdites unités moléculaires comprend une molécule de forme générale sphérique ayant un moment dipolaire.

**6.** Support d'enregistrement tel que revendiqué dans la revendication 5, dans lequel ledit moment dipolaire peut interagir avec un vecteur de champ électrique associé à ladite source lumineuse (64) pour produire une orientation d'une unité moléculaire respective.

**7.** Support d'enregistrement tel que revendiqué dans l'une quelconque des revendications précédentes, dans lequel l'orientation des unités moléculaires dans des zones sélectionnées dudit matériau hôte (71) fournit une réponse anisotrope photo-induite.

**8.** Support d'enregistrement tel que revendiqué dans l'une quelconque des revendications précédentes, dans lequel :

les zones dudit matériau hôte (71) dans lesquelles lesdites unités moléculaires sont orientées de manière commune ont un indice de réfraction différent des zones dudit matériau hôte dans lesquelles lesdites unités moléculaires ne sont pas orientées de cette manière commune.

**9.** Support d'enregistrement tel que revendiqué dans l'une quelconque des revendications 1 à 7, dans lequel :

les zones dudit matériau hôte (71) dans lesquelles lesdites unités moléculaires sont orientées de manière commune ont un indice d'absorption différent des zones dudit matériau hôte dans lesquelles lesdites unités moléculaires ne sont pas orientées de cette manière commune.

**10.** Support d'enregistrement tel que revendiqué dans l'une quelconque des revendications précédentes, dans lequel lesdites unités moléculaires comprennent un matériau semi-conducteur.

**11.** Support d'enregistrement tel que revendiqué dans l'une quelconque des revendications précédentes, dans lequel lesdites unités moléculaires comprennent un film mince déposé sur ledit matériau hôte.

**12.** Support d'enregistrement tel que revendiqué dans l'une quelconque des revendications précédentes, comprenant en outre :

un capsulage comprenant une couche protectrice transparente couvrant sensiblement la surface dudit support d'enregistrement.

**13.** Procédé de formation d'un élément holographique comprenant les étapes consistant à :

chauffer un matériau hôte amorphe (71) au-dessus d'une température de transition prédéterminée à laquelle ledit matériau subit un changement de phase thermodynamique, depuis un premier vers un second état thermodynamique ;
illuminer sélectivement ledit matériau hôte via une source lumineuse (64), pour orienter ainsi des unités moléculaires photosensibles enrobées dans ledit matériau hôte (71) en réponse à la lumière d'illumination ; et
refroidir ensuite ledit matériau hôte (71) en dessous de ladite température de transition, jusqu'à une température à laquelle ledit matériau hôte (71) se trouve dans ledit premier état thermodynamique, fixant ainsi sensiblement l'orientation desdites unités moléculaires ;

dans lequel lesdites unités moléculaires comprennent des composés moléculaires du type $A_4B_3$ ou $A_4B_4$, où A est du phosphore ou de l'arsenic et B est du soufre, du sélénium ou du tellure.

**14.** Procédé tel que revendiqué dans la revendication 13, dans lequel ledit matériau hôte (71) comprend un matériau de matrice vitreux, inorganique.

**15.** Procédé tel que revendiqué dans la revendication 13, dans lequel ledit matériau hôte (71) comprend un matériau de matrice cristallin, inorganique.

**16.** Procédé tel que revendiqué dans la revendication 13, dans lequel ledit matériau hôte (71) comprend un verre de chalcogénure.

**17.** Procédé tel que revendiqué dans l'une quelconque des revendications 13 à 16, dans lequel ladite étape d'orientation comprend l'illumination du matériau hôte (71) avec une lumière polarisée.

**18.** Procédé tel que revendiqué dans l'une quelconque des revendications 13 à 17, dans lequel ladite source lumineuse (64) comprend une source de lumière en polarisation linéaire.

**19.** Procédé tel que revendiqué dans la revendication 18, dans lequel ladite source lumineuse (64) comprend un laser.

**20.** Procédé tel que revendiqué dans l'une quelconque des revendications 13 à 16, dans lequel ladite source lumineuse (64) comprend une source de lumière en polarisation circulaire.

**21.** Procédé tel que revendiqué dans l'une quelconque des revendications 13 à 20, comprenant en outre les étapes consistant à :

faire varier l'indice de réfraction dans des régions dudit matériau hôte (71) dans lesquelles lesdites unités moléculaires sont orientées de manière commune, comparé à l'indice de réfraction dans les régions dudit matériau hôte (71) qui ne sont pas orientées de cette manière.

**22.** Procédé tel que revendiqué dans l'une quelconque des revendications 13 à 20, comprenant en outre les étapes consistant à :

faire varier l'indice d'absorption dans des régions dudit matériau hôte (71) dans lesquelles lesdites unités moléculaires sont orientées de manière commune, comparé à l'indice d'absorption dans les régions dudit matériau hôte (71) qui ne sont pas orientées de cette manière.

**23.** Procédé tel que revendiqué dans l'une quelconque des revendications 13 à 22, dans lequel ledit matériau hôte (71) est chauffé par un chauffage extérieur.

**24.** Procédé tel que revendiqué dans l'une quelconque des revendications 13 à 22, dans lequel ledit matériau hôte (71) est chauffé par absorption d'une lumière de laser polarisée.

**25.** Procédé tel que revendiqué dans l'une quelconque des revendications 13 à 24, dans lequel ledit premier état thermodynamique comprend l'état solide.

**26.** Procédé tel que revendiqué dans l'une quelconque des revendications 13 à 25, dans lequel ledit second état thermodynamique comprend un état semblable à un état plastique.

**27.** Procédé tel que revendiqué dans l'une quelconque des revendications 13 à 26, dans lequel ledit matériau hôte (71) est sensiblement solide à la température ambiante.

**28.** Procédé tel que revendiqué dans l'une quelconque des revendications 13 à 27, dans lequel ladite étape d'orientation des unités moléculaires comprend, pour chaque unité, l'alignement d'un moment dipolaire associé à l'unité moléculaire avec le vecteur électrique associé à la lumière d'illumination.

**29.** Procédé tel que revendiqué dans l'une quelconque des revendications 13 à 28, comprenant en outre les étapes consistant à :

orienter de manière réversible lesdites unités moléculaires.

**30.** Procédé tel que revendiqué dans l'une quelconque des revendications 13 à 29, comprenant en outre les étapes consistant à :

chauffer à nouveau le matériau hôte (71) au-dessus de ladite température de transition prédéterminée ;
orienter à nouveau les unités moléculaires via une source lumineuse (64) ; et
refroidir ledit matériau hôte (71) en dessous de ladite température de transition prédéterminée.

FIG. 1

FIG. 2

FIG. 3

FIG. 4

EP 1 242 997 B1

FIG. 5

EP 1 242 997 B1